# EUROPEAN PATENT SPECIFICATION

(11) **EP 3 454 408 B1**
(45) Date of publication and mention of the grant of the patent: **21.07.2021**
(21) Application number: 18187650.9
(22) Date of filing: 07.08.2018
(51) Int. Cl.: H01M 50/287, H01M 50/204, H01M 10/42, H01M 50/147

(54) **BATTERY MODULE**
BATTERIEMODUL
MODULE DE BATTERIE

(30) Priority: 06.09.2017 CN 201721139981 U
(43) Date of publication of application: 13.03.2019
(73) Proprietor: Contemporary Amperex Technology Co., Limited, Jiaocheng District Ningde City, Fujian 352100 (CN)
(72) Inventor: LI, Jianwei, Ningde, Fujian 352100 (CN); YANG, Mingping, Ningde, Fujian 352100 (CN); ZHENG, Songtai, Ningde, Fujian 352100 (CN)
(74) Representative: Manitz Finsterwald Patent- und Rechtsanwaltspartnerschaft mbB

(56) References cited:
- EP-A2- 2 228 850
- JP-A- 2003 282 036
- US-A1- 2014 023 897
- US-A1- 2015 287 964

## Description

### FIELD OF THE INVENTION

The present invention relates to the field of battery technology, and particularly relates to a battery module. The features of the preamble of the independent claim are known from US 2015/287964 A1. Related technologies are known from EP 2 228 850 A2, US 2014/023897 A1, and JP 2003 282036 A.

### BACKGROUND OF THE INVENTION

At present, the use of a flexible printed circuit board (abbreviated as FPC) in the battery module is becoming more and more frequent, and using the FPC to collect low-voltage signals and temperature signals is a technique that has been promoting. Because of the structure and flexibility of the FPC itself, the FPC is usually fixed to the other components (such as batteries) of the battery module using a double-sided adhesive tape or a double-sided gum tape, but such a fixing method has the following two obvious defects: (1) the double-sided adhesive tape or the conventional double-sided gum tape has high requirements for the adhered surface, and the material of the adhered surface must adhere the adhesive of the double-sided adhesive tape or the adhesive of the conventional double-sided gum tape, for example, when the material of the components such as the battery is polypropylene (PP), the conventional double-sided gum tape can not adhere to the surface of the components to form a stable adhesive layer, which can not play a fixing role; (2) the double-sided adhesive tape or the double-sided gum take has a short service life, most of them can not meet the service life requirement of the battery module, and even if some types of the double-sided adhesives can meet the service life requirement of the battery module, the cost of them will be relatively high and the practicality is not good. In addition, the fixing method of adhering the adhesive also greatly influences the automatic production of the battery module. At present, the double-sided adhesive tape or the double-sided gum tape is manually adhered by hand, and there are also some situations which are not beneficial to the production, for example the wrinkle and the like are formed during the adhering process.

### SUMMARY OF THE INVENTION

In view of the problem existing in the background, an object of the present invention is to provide a battery module, which can stably and efficiently fix the FPC, improves the fixation reliability of the FPC, facilitates the automatic production and reduces the cost. The present invention is defined in the independent claim.

In order to achieve the above object, the present invention provides a battery module, which comprises: a plurality of batteries arranged side by side in a length direction, each battery includes a cap assembly, the cap assembly includes a cap plate; and a FPC positioned above the cap plates of the plurality of batteries in a height direction. The cap plate of at least one battery is provided with a fixing column, the FPC is provided with a positioning hole at a position corresponding to the fixing column of the battery. The fixing column has: a rod portion received in the positioning hole of the FPC, one end of the rod portion is fixed to the cap plate; and a cover portion connected with the other end of the rod portion, covering the positioning hole and fixed to the FPC. The cover portion of the fixing column is formed by hot-melting and solidifying the other end of the rod portion.

The present invention has the following beneficial effects: in the battery module according to the present invention, the rod portion of the fixing column is received in the positioning hole of the FPC and the one end of the rod portion is fixed to the cap plate, and the cover portion of the fixing column is connected with the other end of the rod portion, covers the positioning hole and is fixed to the FPC, therefore the FPC is fixed to the corresponding battery. The method for fixing the FPC of the battery module is stable and effective, improves the fixation reliability of the FPC, facilitates the automatic production and reduces the cost of the battery module. Moreover, compared with the fixing method of adhering the adhesive mentioned in the background, the method for fixing the FPC in the battery module of the present invention has more wide applicable range, avoids the situations which are not beneficial to production, for example the wrinkle and the like which are formed during the adhering process manually performed by hand, and is beneficial to improve the production efficiency.

### BRIEF DESCRIPTION OF THE DRAWINGS

FIG. 1 is a perspective view of a battery module not according to the present invention, in which a fixing column is not hot-melted.
FIG. 2 is a perspective view of the battery module according to the present invention, in which the fixing column has been hot-melted.
FIG. 3 is a perspective view of one of batteries of the battery module of FIG. 1.
FIG. 4 is a cross sectional view taken along an A-A line of FIG. 3.
FIG. 5 is a perspective view of a FPC of the battery module of FIG. 1.
FIG. 6 is a perspective view of the fixing column of the battery module of FIG. 1.
FIG. 7 is a perspective view of the fixing column of the battery module of FIG. 2.
FIG. 8 is a schematic view illustrating a connection between the fixing column and a positioning hole of the FPC of the battery module.
FIG. 9 is a varied example of FIG. 8.

### Reference numerals are represented as follows:

1 battery
11 cap assembly
111 cap plate
112 electrode terminal
12 case
13 electrode assembly
2 FPC
21 positioning hole
3 electrical connection piece
B fixing column
B1 rod portion
B2 cover portion
L length direction
H height direction
W width direction

### DETAILED DESCRIPTION

Hereinafter a battery module according to the present invention will be described in detail in combination with the figures.

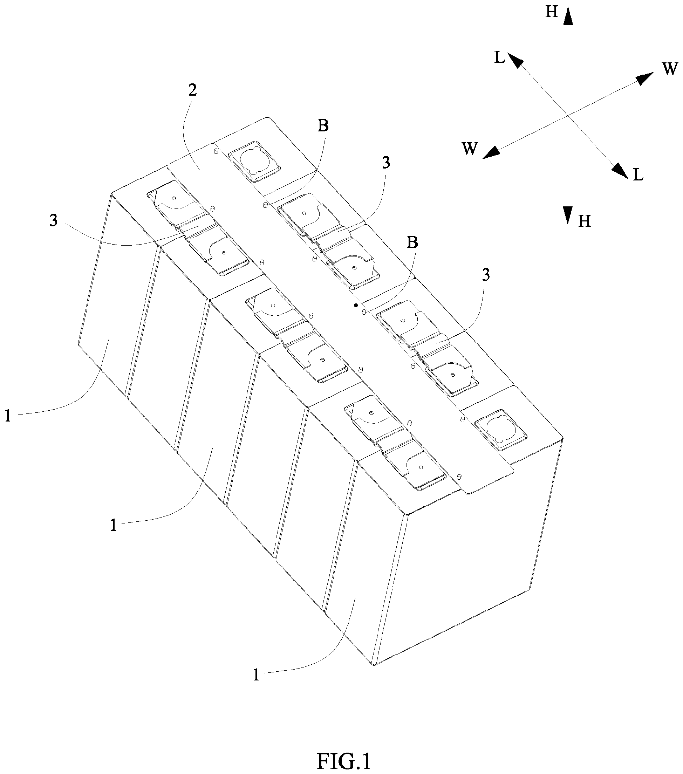

Referring to FIG. 1 to FIG. 9, a battery module according to the present invention comprises: a plurality of batteries 1 arranged side by side in a length direction L, each battery 1 includes a cap assembly 11, the cap assembly 11 includes a cap plate 111; and a FPC 2 positioned above the cap plates 111 of the plurality of batteries 1 in a height direction H. The cap plate 111 of at least one battery 1 is provided with a fixing column B, the FPC 2 is provided with a positioning hole 21 at a position corresponding to the fixing column B of the battery 1. The fixing column B has: a rod portion B1 received in the positioning hole 21 of the FPC 2, one end of the rod portion B1 is fixed to the cap plate 111; and a cover portion B2 connected with the other end of the rod portion B1, covering the positioning hole 21 and fixed to the FPC 2.

In the battery module according to the present invention, the rod portion B1 of the fixing column B is received in the positioning hole 21 of the FPC 2 and the one end of the rod portion B1 is fixed to the cap plate 111, and the cover portion B2 of the fixing column B is connected with the other end of the rod portion B1, covers the positioning hole 21 and is fixed to the FPC 2, therefore the FPC 2 is fixed to the corresponding battery 1. The method for fixing the FPC 2 of the battery module is stable and effective, improves the fixation reliability of the FPC 2, facilitates the automatic production and reduces the cost of the battery module. Moreover, compared with the fixing method of adhering the adhesive mentioned in the background, the method for fixing the FPC 2 in the battery module of the present invention has more wide applicable range, and avoids the situations which are not beneficial to production, for example the wrinkle and the like which are formed during the adhering process manually performed by hand, is beneficial to improve the production efficiency.

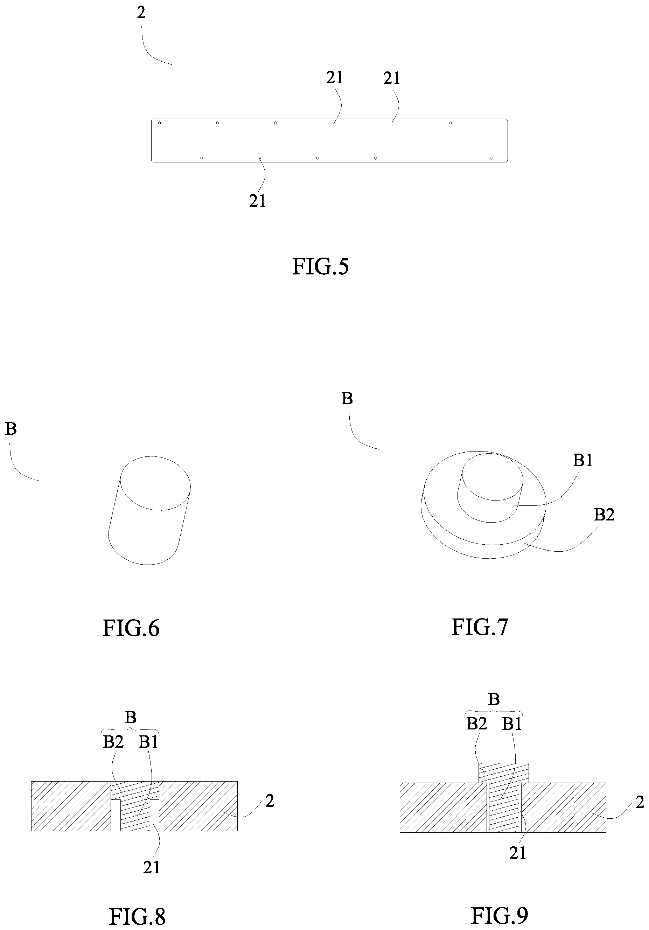

When a diameter of the positioning hole 21 of the FPC 2 is far larger than a diameter of the rod portion B1 of the fixing column B, the cover portion B2 may be fixed inside the positioning hole 21 of the FPC 2, and a top surface of the cover portion B2 is coplanar with an upper surface of the FPC 2, as shown in FIG. 8.

When the diameter of the positioning hole 21 of the FPC 2 is slightly larger than the diameter of the rod portion B1 of the fixing column B, the cover portion B2 may be fixed outside the positioning hole 21 of the FPC 2, and the top surface of the cover portion B2 is higher than the upper surface of the FPC 2, as shown in FIG. 9.

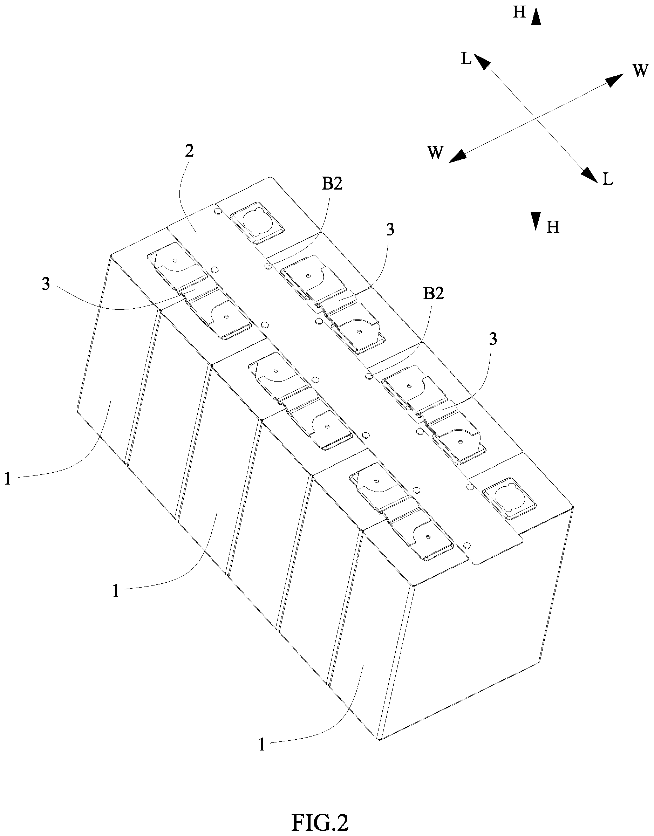

According to the invention, the cover portion B2 of the fixing column B is formed by hot-melting one end of the rod portion B1 away from the cap plate 111. Specifically, after the battery module are assembled, the positioning hole 21 of the FPC 2 is aligned with the corresponding fixing column B of the cap plate 111 of the battery 1 and makes the fixing column B (at this moment, the fixing column B only has the rod portion B1, as shown in FIG. 1 and FIG. 6) inserted into the positioning hole 21, after the rod portion B1 of the fixing column B inserted into the positioning hole 21, the end of the rod portion B1 away from the cap plate 111 extends out of the positioning hole 21, then the portion of the rod portion B1 extending out of the positioning hole 21 is hot-melted using a hot-melting equipment, thus the cover portion B2 is formed after the portion of the rod portion B1 is solidified (as shown in FIG. 2 and FIG. 7). Meanwhile, with the forming of the cover portion B2, the FPC 2 is fixed to the cap plate 111 of the battery 1. The hot-melting process for fixing the FPC 2 is rapid and effective, improves the fixation reliability of the FPC 2. Certainly, if the fixing column B meets the requirement on the plastic capability of material, the end of the rod portion B1 away from the cap plate 111 is plastically deformed by a pressing method (such as stamping) to form the cover portion B2.

In order to improve the structural stability, an adhesive can be provided between two adjacent larger surfaces of every two adjacent batteries 1, which ensures that there is no misalignment between every two adjacent batteries 1 in the process of mounting the FPC 2 to the corresponding cap plate 111 of the battery 1.

The arrangement of the fixing column B on the corresponding battery 1 can be determined depending on the requirements. At least each battery 1 at a middle of the plurality of batteries 1 arranged sided by side in the length direction L is provided with the fixing column B; or at least each of the two batteries 1 respectively at two ends of the plurality of batteries 1 arranged side by side in the length direction L is provided with the fixing column B. These two arrangements are mainly applicable to the case that the number of the batteries 1 is small relatively, which ensures the fixation reliability of the FPC 2 and reduces the number of the fixing columns B (namely, there is no need to provide the fixing columns B on every battery 1), thus the cost is saved. In addition, each of the plurality of batteries 1 arranged side by side in the length direction L is provided with the fixing column B. This arrangement can ensure that every portion of the FPC 2 can be fixed reliably, and then the fixation reliability of the FPC 2 is the best. It should be noted that, based on the number of the batteries 1 of the battery module, it needs to reasonably determine the number of the fixing columns B and select the mounting positions of the fixing columns B provided on the batteries 1 arranged side by side in the length direction L while ensuring the fixation reliability of the FPC 2.

The fixing column B on the battery 1 which is provided with the fixing column B can be provided as one or multiple in number. When the fixing column B on the battery 1 which is provided with the fixing column B is provided as multiple in number, the multiple fixing columns B on the same battery 1 are in a matrix array arrangement or a staggered arrangement.
Certainly, the arrangement of the multiple fixing columns B can be not only limited to the matrix array arrangement or/ and the staggered arrangement, it also can be used other arrangement, and it can be determined reasonably based on the number of the fixing columns B.

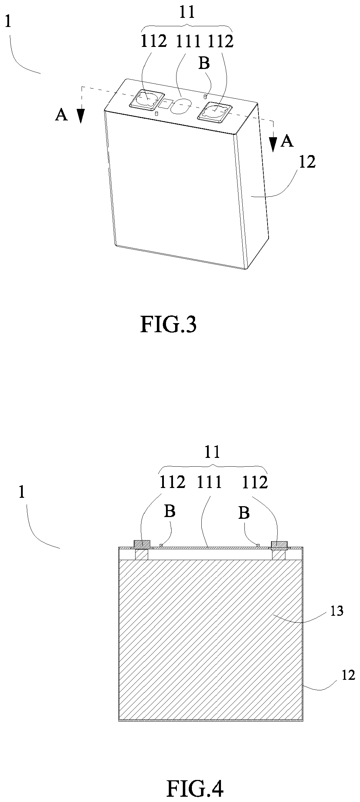

Referring to FIG. 3 and FIG. 4, each battery 1 may further comprise: a case 12; an electrode assembly 13 received in the case 12; and a cap assembly 11 mounted to the case 12.

Referring to FIG. 3 and FIG. 4, the cap plate 111 is mounted to the case 12. The cap assembly 11 may further comprise: two electrode terminals 112 electrically connected with the electrode assembly 13, passing through and fixed to the cap plate 111.

The fixing column B and the cap plate 111 can be made of the same material, for example the cover plate 111 can be made of a metal material, correspondingly the fixing column B also can be made of the metal material. Certainly, the fixing column B and the cap plate 111 can be made of different materials, for example the fixing column B can be made of a resin material, and the cap plate 111 can be made of a metal material. Here, because the temperature resistance capability of the FPC 2 is high, the fixing column B also can use a hot-melt material having the relatively high melting temperature, such as the polypropylene (PP) or the polyethylene terephthalate (PET).

Referring to FIG. 1 and FIG. 2, the battery module may further comprise a plurality of electrical connection pieces 3, each electrical connection piece 3 is electrically connected with two adjacent batteries 1 to realize serial connection or/and parallel connection among the plurality of batteries 1.

## Claims

1. A battery module, comprising:
a plurality of batteries (1) arranged side by side in a length direction (L), each battery (1) including a cap assembly (11), the cap assembly (11) including a cap plate (111); and
a flexible printed circuit board, FPC, (2) positioned above the cap plates (111) of the plurality of batteries (1) in a height direction (H);
wherein the cap plate (111) of at least one battery (1) is provided with a fixing column (B);
the FPC (2) is provided with a positioning hole (21) at a position corresponding to the fixing column (B) of the battery (1);
the fixing column (B) has: a rod portion (B1) received in the positioning hole (21) of the FPC (2), one end of the rod portion (B1) is fixed to the cap plate (111); and a cover portion (B2) covering the positioning hole (21) and fixed to the FPC (2);
**characterized in that**
the cover portion (B2) of the fixing column (B) is formed by hot-melting and solidifying the other end of the rod portion (B1).

2. The battery module according to Claim 1, wherein the cover portion (B2) is fixed inside the positioning hole (21) of the FPC (2), and a top surface of the cover portion (B2) is coplanar with an upper surface of the FPC (2).

3. The battery module according to Claim 1, wherein the cover portion (B2) is fixed outside the positioning hole (21) of the FPC (2), and a top surface of the cover portion (B2) is higher than an upper surface of the FPC (2).

4. The battery module according to Claim 1, wherein
at least each battery (1) between two ends of the plurality of batteries (1) arranged side by side in the length direction (L) is provided with the fixing column (B); or
at least each of two batteries (1) respectively at the two ends of the plurality of batteries (1) arranged side by side in the length direction (L) is provided with the fixing column (B); or
each of the plurality of batteries (1) arranged side by side in the length direction (L) is provided with the fixing column (B).

5. The battery module according to Claim 1, wherein the fixing column (B) on the battery (1) which is provided with the fixing column (B) is provided as one in number.

6. The battery module according to Claim 1, wherein the fixing column (B) on the battery (1) which is provided with the fixing column (B) is provided as multiple in number.

7. The battery module according to Claim 6, wherein the multiple fixing columns (B) on the same battery (1) are in a matrix array arrangement or a staggered arrangement.

8. The battery module according to Claim 1, wherein the fixing column (B) and the cap plate (111) are made of the same material.

9. The battery module according to Claim 1, wherein the fixing column (B) and the cap plate (111) are made of different materials.

10. The battery module according to Claim 9, wherein the fixing column (B) is made of a resin material, and the cap plate (111) is made of a metal material.

## Patentansprüche

1. Batteriemodul, umfassend:
eine Mehrzahl von Batterien (1), die in einer Längsrichtung (L) Seite an Seite angeordnet sind, wobei jede Batterie (1) eine Deckanordnung (11) enthält, wobei die Deckanordnung (11) eine Deckplatte (111) enthält; und
eine flexible Leiterplatte, FPC, (2), die über den Deckplatten (111) der Mehrzahl von Batterien (1) in einer Höhenrichtung (H) angeordnet ist;
wobei die Deckplatte (111) mindestens einer Batterie (1) mit einer Befestigungssäule (B) versehen ist;
die FPC (2) mit einem Positionierungsloch (21) an einer Position versehen is, die der Befestigungssäule (B) der Batterie (1) entspricht;
die Befestigungssäule (B) umfasst: einen Stangenabschnitt (B1), der in dem Positionierungsloch (21) der FPC (2) aufgenommen ist, wobei ein Ende des Stangenabschnitts (B1) an der Deckplatte (111) befestigt ist; und einen Deckabschnitt (B2), der das Positionierungsloch (21) abdeckt und an der FPC (2) befestigt ist;
**dadurch gekennzeichnet, dass**
der Deckabschnitt (B2) der Befestigungssäule (B) durch Heißschmelzen und Verfestigen des anderen Endes des Stangenabschnitts (B1) ausgebildet ist.

2. Batteriemodul nach Anspruch 1, wobei der Deckabschnitt (B2) innerhalb des Positionierungslochs (21) der FPC (2) befestigt ist und eine obere Fläche des Deckabschnitts (B2) koplanar mit einer oberen Fläche der FPC (2) ist.

3. Batteriemodul nach Anspruch 1, wobei der Deckabschnitt (B2) außerhalb des Positionierungslochs (21) der FPC (2) befestigt ist und eine obere Fläche des Deckabschnitts (B2) höher als eine obere Fläche der FPC (2) ist.

4. Batteriemodul nach Anspruch 1, wobei
zumindest jede Batterie (1) zwischen zwei Enden der Mehrzahl von in Längsrichtung (L) Seite an Seite angeordneten Batterien (1) mit der Befestigungssäule (B) versehen ist; oder
zumindest jede von zwei Batterien (1) jeweils an den zwei Enden der Mehrzahl von in Längsrichtung (L) Seite an Seite angeordneten Batterien (1) mit der Befestigungssäule (B) versehen ist; oder
jede der Mehrzahl von in Längsrichtung (L) Seite an Seite angeordneten Batterien (1) mit der Befestigungssäule (B) versehen ist.

5. Batteriemodul nach Anspruch 1, wobei die Befestigungssäule (B) an der Batterie (1), die mit der Befestigungssäule (B) versehen ist, in der Anzahl von eins vorgesehen ist.

6. Batteriemodul nach Anspruch 1, wobei die Befestigungssäule (B) an der Batterie (1), die mit der Befestigungssäule (B) versehen ist, in mehrfacher Anzahl vorgesehen ist.

7. Batteriemodul nach Anspruch 6, wobei die mehreren Befestigungssäulen (B) an derselben Batterie (1) in einer Matrixgruppierungsanordnung oder einer gestaffelten Anordnung vorliegen.

8. Batteriemodul nach Anspruch 1, wobei die Befestigungssäule (B) und die Deckplatte (111) aus dem gleichen Material hergestellt sind.

9. Batteriemodul nach Anspruch 1, wobei die Befestigungssäule (B) und die Deckplatte (111) aus verschiedenen Materialien hergestellt sind.

10. Batteriemodul nach Anspruch 9, wobei die Befestigungssäule (B) aus einem Harzmaterial hergestellt ist und die Deckplatte (111) aus einem Metallmaterial hergestellt ist.

## Revendications

1. Module de batteries, comprenant :
une pluralité de batteries (1) disposées côte à côte dans une direction de longueur (L), chaque batterie (1) incluant un ensemble de recouvrement (11), l'ensemble de recouvrement (11) incluant une plaque de recouvrement (111) ; et
une carte de circuit imprimé flexible, FPC, (2) positionnée au-dessus des plaques de recouvrement (111) de la pluralité de batteries (1) dans une direction de hauteur (H) ;
dans lequel la plaque de recouvrement (111) d'au moins une batterie (1) est pourvue d'une colonnette de fixation (B) ;
la FPC (2) est pourvue d'un trou de positionnement (21) à une position correspondant à la colonnette de fixation (B) de la batterie (1) ;
la colonnette de fixation (B) présente une partie tige (B1) reçue dans le trou de positionnement (21) de la FPC (2), une extrémité de la partie tige (B1) est fixée à la plaque de recouvrement (111) ; et une partie couvercle (B2) couvrant le trou de positionnement (21) et fixée à la FPC (2) ;
**caractérisé en ce que**
la partie couvercle (B2) de la colonnette de fixation (B) est formée par fusion et solidification de l'autre extrémité de la partie tige (B1).

2. Module de batteries selon la revendication 1, dans lequel la partie couvercle (B2) est fixée à l'intérieur du trou de positionnement (21) de la FPC (2) et une surface supérieure de la partie couvercle (B2) est coplanaire avec une surface supérieure de la FPC (2).

3. Module de batteries selon la revendication 1, dans lequel la partie couvercle (B2) est fixée à l'extérieur du trou de positionnement (21) de la FPC (2) et une surface supérieure de la partie couvercle (B2) est plus haute qu'une surface supérieure de la FPC (2).

4. Module de batteries selon la revendication 1, dans lequel
au moins chaque batterie (1) entre deux extrémités de la pluralité de batteries (1) disposées côte à côte dans la direction de longueur (L) est pourvue de la colonnette de fixation (B) ; ou
au moins chacune de deux batteries (1) respectivement aux deux extrémités de la pluralité de batteries (1) disposées côte à côte dans la direction de longueur (L) est pourvue de la colonnette de fixation (B) ;
ou chacune de la pluralité de batteries (1) disposées côte à côte dans la direction de longueur (L) est pourvue de la colonnette de fixation (B).

5. Module de batteries selon la revendication 1, dans lequel la colonnette de fixation (B) sur la batterie (1) qui est pourvue de la colonnette de fixation (B) est prévue en nombre unique.

6. Module de batteries selon la revendication 1, dans lequel la colonnette de fixation (B) sur la batterie (1) qui est pourvue de la colonnette de fixation (B) est prévue en nombre multiple.

7. Module de batteries selon la revendication 6, dans lequel les multiples colonnettes de fixation (B) sur la même batterie (1) sont disposées selon un agencement en matrice ou un agencement en quinconce.

8. Module de batteries selon la revendication 1, dans lequel la colonnette de fixation (B) et la plaque de recouvrement (111) sont constituées du même matériau.

9. Module de batteries selon la revendication 1, dans lequel la colonnette de fixation (B) et la plaque de recouvrement (111) sont constituées de matériaux différents.

10. Module de batteries selon la revendication 9, dans lequel la colonnette de fixation (B) est constituée d'un matériau résinique et la plaque de recouvrement (111) est constituée d'un matériau métallique.
